(19) Europäisches Patentamt
European Patent Office
Office européen des brevets

(11) **EP 3 213 096 B1**

(12) **EUROPÄISCHE PATENTSCHRIFT**

(45) Veröffentlichungstag und Bekanntmachung des Hinweises auf die Patenterteilung:
**01.08.2018** **Patentblatt 2018/31**

(21) Anmeldenummer: **15804478.4**

(22) Anmeldetag: **03.12.2015**

(51) Int Cl.:
**G01R 31/34** *(2006.01)*     *G01R 19/175* *(2006.01)*
**H02P 29/024** *(2016.01)*

(86) Internationale Anmeldenummer:
**PCT/EP2015/078443**

(87) Internationale Veröffentlichungsnummer:
**WO 2016/113035 (21.07.2016 Gazette 2016/29)**

(54) **VERFAHREN ZUM DETEKTIEREN VON WINDUNGSSCHLÜSSEN**

METHOD FOR DETECTING INTER-TURN-SHORTS

PROCÉDÉ DE DÉTECTION DE COURT-CIRCUIT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.01.2015 EP 15151158**

(43) Veröffentlichungstag der Anmeldung:
**06.09.2017 Patentblatt 2017/36**

(73) Patentinhaber: **Siemens Aktiengesellschaft 80333 München (DE)**

(72) Erfinder:
• **SCHÖNFELDER, Oliver 58300 Wetter (Ruhr) (DE)**
• **THIEN, Dagmar 45131 Essen (DE)**

(56) Entgegenhaltungen:
**EP-A1- 0 608 442    WO-A1-2013/136098 GB-A- 2 457 590**

• **ALBRIGHT D R: "Interturn Short-Circuit Detector for Turbine-Generator Rotor Windings", IEEE TRANSACTIONS ON POWER APPARATUS AND SYSTEMS, IEEE INC. NEW YORK, US, Bd. 82, Nr. 2, 1. März 1971 (1971-03-01), Seiten 478-483, XP011160451, ISSN: 0018-9510**

**Beschreibung**

Die Erfindung betrifft ein Verfahren zum Detektieren von Läuferwindungsschlüssen in einer elektrischen Maschine.

Elektrische Maschinen, wie Generatoren oder Motoren, weisen einen Stator und einen Läufer auf. Der Läufer weist zur Erzeugung eines Magnetsfelds eine Wicklung elektrischer Leiter auf. Eine Isolation ummantelt die elektrischen Leiter, um sie gegen benachbart angeordnete Windungen der Wicklung und gegen die Umgebung elektrisch zu isolieren.

Fehlstellen in der Isolation des Läufers können zu Windungsschlüssen führen, also zu Kurzschlüssen zwischen benachbart angeordneten Windungen der Wicklung. Dies führt dazu, dass die kurzgeschlossenen Windungen der Wicklung von einem geringeren Erregerstrom durchströmt werden als die nicht kurzgeschlossenen Windungen der Wicklung, wodurch die kurzgeschlossenen Windungen eine niedrigere Temperatur als die nicht kurzgeschlossenen Windungen haben. Dies kann zu einer inhomogenen Betriebstemperatur des Läufers führen. Die inhomogene Betriebstemperatur kann zu mechanischen Spannungen innerhalb des Läufers führen, wobei die Spannungen zu einer Abweichung der Massenverteilung von der Rotationssymmetrie führen können. Die unsymmetrische Massenverteilung kann zu Schwingungen des Läufers im Betrieb der elektrischen Maschine führen. Zudem führt der Windungsschluss zu einer Abschwächung des Magnetfeldes, was durch einen höheren Erregerstrom kompensiert werden muss. Der höhere Erregerstrom führt nachteilig zu einer Verringerung des Wirkungsgrades der elektrischen Maschine.

Im Betrieb der elektrischen Maschine werden Windungsschlüsse mittels eines Luftspaltspulen-Messverfahrens ermittelt, bei dem mittels einer Spule der magnetische Fluss an Orten zwischen dem Läufer und dem Stator gemessen wird. Dazu ist es erforderlich eine halbe Umdrehung des Läufers in dem mittels der Spule erzeugten Signalverlauf zu identifizieren. Weil der Signalverlauf von einem Rauschsignal überlagert sein kann, kann das Identifizieren der halben Umdrehung des Läufers jedoch fehlerbehaftet sein, so dass die Auswertung des Luftspaltspulen-Messverfahren zu uneindeutigen Ergebnissen führen kann.

Aus der GB 2 457 590 A ist bereits ein Verfahren zum Detektieren von Windungsschlüssen in einer elektrischen Maschine entnehmbar, bei dem die Schritte:

- Anordnen einer Spule in einen zwischen dem Läufer und dem Stator der elektrischen Maschine angeordneten Luftspalt;
- Berechnen einer Mindestdauer von zwei zeitlich aufeinanderfolgen Nulldurchgängen eines mittels der Spule erzeugten Signalverlaufs unter Heranziehen der Drehfrequenz und der Polpaarzahl der elektrischen Maschine;

- Aufnehmen im Betrieb der elektrischen Maschine des mittels der Spule erzeugten Signalverlaufs, der mindestens die Dauer einer Läuferumdrehung aufweist;

durchgeführt werden.

Aufgabe der Erfindung ist es, ein Verfahren zum Detektieren von Windungsschlüssen in einer Wicklung einer elektrischen Maschine zu schaffen, bei dem die Aufnahme und Auswertung des Signalverlaufs einfach ist und die Windungsschlüsse mit einer hohen Genauigkeit detektierbar sind.

Die Aufgabe wird durch das Verfahren mit den Merkmalen des Patentanspruchs 1 gelöst.

Das erfindungsgemäße Verfahren zum Detektieren von Windungsschlüssen in einer elektrischen Maschine weist die Schritte auf: a) Anordnen einer Spule in einen zwischen dem Läufer und dem Stator der elektrischen Maschine angeordneten Luftspalt; b) Berechnen einer Mindestdauer von zwei zeitlich unmittelbar aufeinanderfolgen Nulldurchgängen eines mittels der Spule erzeugten Signalverlaufs U(t) unter Heranziehen der Drehfrequenz und der Polpaarzahl der elektrischen Maschine; c) Aufnehmen im Betrieb der elektrischen Maschine des mittels der Spule erzeugten Signalverlaufs U(t), der mindestens die Dauer einer Läuferumdrehung aufweist; d) Bestimmen der Nulldurchgänge des Signalverlaufs U(t) und Speichern der Zeitpunkte dieser Nulldurchgänge; e) Bestimmen der Nulldurchgänge des mit einem Offset c korrigierten Signalverlaufs U(t)-c und Identifizieren mindestens eines Paares an unmittelbar aufeinander folgenden Nulldurchgängen, dessen Zeitabstand länger als die Mindestdauer ist, wobei c ungleich Null ist; f) in dem Fall, dass in Schritt e) kein Paar identifiziert wurde, Wiederholen von Schritt e) bis ein Paar identifiziert wird, wobei der Offset c in Richtung von dem Nullpunkt zu einem globalen Extremwert des Signalverlaufs U(t) variiert wird; g) Identifizieren mindestens eins der beiden der gespeicherten Zeitpunkte, die zeitlich zwischen und zeitlich am nahesten an dem Paar liegen; h) Extrahieren aus dem Signalverlauf U(t) von zwei Halbwellen unter Heranziehen der in Schritt g) identifizierten Zeitpunkte, wobei jede Halbwelle einer halben Umdrehung des Läufers entspricht; i) Vergleichen der beiden Halbwellen.

In Schritt i) können durch den Vergleich der beiden Halbwellen Asymmetrien in dem magnetischen Feld detektiert werden. Dies kann beispielsweise dadurch erfolgen, dass die beiden Halbwellen zeitlich zur Deckung gebracht werden und anschließend die beiden Halbwellen miteinander addiert werden. Weicht der zeitliche Verlauf der Addition der beiden Halbwellen von einem Wert von Null ab, so kann auf die Asymmetrie geschlossen werden. Aus der Asymmetrie kann dann auf das Vorliegen eines Windungsschluss geschlossen werden.

Nicht alle Nulldurchgänge in dem Signalverlauf U(t) begrenzen eine Halbwelle. Durch das Verfahren werden die Zeitpunkte derjenigen der Nulldurchgänge in dem Signalverlauf U(t) identifiziert, die tatsächlich eine der Halbwellen begrenzen. Das erfindungsgemäße Verfahren beruht auf der Erkenntnis, dass der Zeitabstand von zwei unmittelbar aufeinander folgenden Nulldurchgängen umso größer wird, je größer der Offset c gewählt, mit dem der Signalverlauf U(t) korrigiert wird. Der Begriff unmittelbar aufeinander folgende Nulldurchgänge bedeutet, dass kein weiterer Nulldurchgang zwischen den beiden Nulldurchgängen liegt. Der Offset c wird in Inkrementen von einem Minimalwert bis zu einem Maximalwert variiert, der kleiner als der Extremwert des Signalverlaufs U(t) ist, solange bis das Paar an den unmittelbar aufeinander folgenden Nullpunkten in dem korrigierten Signalverlauf U(t)-c gefunden wird, wobei das Paar einen größeren Abstand hat als die berechnete Mindestdauer. Diejenigen der Nulldurchgänge, die tatsächliche eine Halbwelle begrenzen, liegen zeitlich innerhalb des Paars und sind diejenigen der innerhalb des Paares liegenden Nulldurchgänge, die zeitlich am nahesten an dem Paar liegen. Für jedes Paar gibt es dabei zwei Nulldurchgänge, die tatsächlich eine Halbwelle begrenzen, wobei es in Schritt g) möglich ist entweder eins oder beide Nulldurchgänge zu identifizieren.

Weil in Schritt e) die Nulldurchgänge gesucht werden, deren Zeitabstand länger als die in Schritt b) berechnete Mindestdauer ist und nicht diejenigen Nulldurchgänge, die exakt der berechneten Mindestdauer entsprechen, funktioniert das Verfahren vorteilhaft selbst dann zweifelsfrei, wenn die tatsächliche Drehfrequenz geringfügig von der für die Berechnung in Schritt b) angenommen Drehfrequenz abweicht. Auch funktioniert das Verfahren vorteilhaft ohne die Informationen eines die exakte Drehzahl des Läufers messenden Drehzahlmessers zu verwenden, sondern es reicht aus, die Mindestdauer in Schritt b) grob abzuschätzen.

Das Verfahren ermöglicht es im Vergleich mit dem Stand der Technik auf aufwändige mathematische Methoden und Vergleichsmessungen zu verzichten und ist des Weiteren vorteilhaft derart einfach durchführbar, dass es auch automatisiert durchführbar ist. Weiterhin lassen sich diejenigen Nullstellen, die tatsächlich eine Halbwelle begrenzen, fehlerfrei identifizieren, wodurch das Verfahren mit einer hohen Genauigkeit durchführbar ist.

Das Verfahren weist bevorzugt die Schritte auf: e1) Bestimmen der Nulldurchgänge des mit einem Offset d korrigierten Signalverlaufs U(t)-d und Identifizieren mindestens eines Paares an unmittelbar aufeinander folgenden Nulldurchgängen, dessen Zeitabstand länger als die Mindestdauer ist, wobei d ungleich Null ist und das entgegengesetzte Vorzeichen zu c hat; f1) in dem Fall, dass in Schritt e1) kein Paar identifiziert wurde, Wiederholen von Schritt e1) bis ein Paar identifiziert wird, wobei der Offset d in Richtung von dem Nullpunkt zu dem anderen globalen Extremwert des Signalverlaufs U(t) variiert wird; und wobei in Schritt h eine der beiden Halbwellen unter Heranziehen der in Schritt e1) identifizierten Zeitpunkte extrahiert wird. Wird ein positiver Offset zum Korrigieren des Signalverlaufs U(t) verwendet, lassen sich obere Halbwellen und wird ein negativer Offset zum Korrigieren des Signalverlaufs U(t) verwendet, lassen sich untere Halbwellen identifizieren. Dadurch, dass sowohl der positive als auch der negative Offset verwendet werden, lassen sich vorteilhaft sowohl obere als auch untere Halbwellen identifizieren. Zudem ist es möglich durch einen Vergleich des Integrals der oberen Halbwelle mit dem Integral der unteren Halbwelle festzustellen, ob der Signalverlauf U(t) insgesamt einen Offset aufweist.

Die Polpaarzahl der elektrischen Maschine ist bevorzugt eins und jede der beiden Halbwellen ist von jeweils zwei der in Schritt g) und/oder g1) identifizierten und unmittelbar aufeinander folgenden Zeitpunkten begrenzt. Alternativ ist die Polpaarzahl der elektrische Maschine größer als eins und jede der Halbwellen wird aus einer der Polpaarzahl der elektrischen Maschine identischen Anzahl an Teilwellen gebildet, wobei jede Teilwelle von jeweils zwei der in Schritt g) und/oder g1) identifizierten und unmittelbar aufeinander folgenden Zeitpunkten begrenzt ist. Somit lässt sich das Verfahren vorteilhaft bei einer elektrischen Maschine mit einer beliebigen Anzahl an Polpaarzahlen durchführen.

Es ist bevorzugt, dass in Schritten d), e) und/oder e1) die Nulldurchgänge (6 bis 9) mittels Bilden von $y_0 = U_{t=\alpha} * U_{t=\alpha+1}$ für alle Punkte des Signalverlaufs U(t) und des korrigierten Signalverlaufs U(t)-c bestimmt werden, wobei $U_{t=\alpha}$ ein Signalwert in U(t) oder U(t)-c ist und $U_{t=\alpha+1}$ der unmittelbar darauf folgende Signalwert ist. Ist $y_0=0$, so ist mindestens einer der beiden Signalwerte ein Nulldurchgang. Ist $y_0>0$, so liegt kein Nulldurchgang vor. Ist $y_0<0$, so liegt ein Nulldurchgang zwischen den beiden Signalwerten vor. Bevorzugt werden in dem Fall, dass $y_0$ negativ ist, zum Bestimmen des Nulldurchgangs die beiden zu $U_{t=\alpha}$ und $U_{t=\alpha+1}$ gehörigen Punkte linear interpoliert. Dadurch lassen sich die Nulldurchgänge vorteilhaft mit einer höheren Auflösung bestimmen als der Zeitabstand der Messpunkte in dem Signalverlauf U(t). Beispielsweise kann die lineare Interpolation mittels folgender Gleichung durchgeführt werden:

$$0 = \frac{U_{t=\alpha+1} - U_{t=\alpha}}{t_{\alpha+1} - t_\alpha} \cdot \left(t - t_\alpha\right) + U_{t=\alpha},$$

wobei $t_\alpha$ der zu $U_{t=\alpha}$ gehörende Zeitpunkt und $t_{\alpha+1}$ der zu $U_{t=\alpha+1}$ gehörende Zeitpunkt ist. Durch Umstellen der Gleichung nach t kann der Nulldurchgang bestimmt werden.

Es ist bevorzugt, dass der Signalverlauf U(t) die in der Spule erzeugte elektrische Spannung oder die in der Spule erzeugte Stromstärke aufweist. Der in Schritt c) aufgenommene Signalverlauf U(t) wurde bevorzugt mittels einem Filter, insbesondere ein Bezier-Filter, ein Median-Filter und/oder ein Gradienten-Filter, geglättet. Dadurch lassen sich Verzerrungen in dem Signal aufgrund von mechanischen und elektromagnetischen Einflüssen beseitigen, so dass die Nulldurchgänge mit einer hohen Genauigkeit bestimmt werden können. Die elektrische Maschine ist bevorzugt ein Generator, insbesondere eine Synchronmaschine, und/oder ein Elektromotor.

Im Folgenden wird anhand der beigefügten schematischen Zeichnung die Erfindung näher erläutert. Es zeigen:

Figur 1    einen Signalverlauf mit einer Grundharmonischen,

Figur 2    die Grundharmonische $U_G(t)$ mit einer Funktion $f_c(t)=c$, wobei $c>0$,

Figur 3    den Signalverlauf $U(t)$ mit einer der Grundharmonischen $U_G(t)$,

Figur 4    den Signalverlauf mit einer Funktion $f_1(t)=c_1$, wobei $c_1>0$,

Figur 5    den Signalverlauf mit einer Funktion $f_2(t)=c_2$, wobei $c_2>c_1>0$,

Figur 6    ein Detail aus Figur 5,

Figur 7, 8    eine schematische Darstellung eines Vergleiches von zwei Halbwellen,

Figur 9    einen Signalverlauf mit zwei Fehlerpositionen,

Figur 10    einen Querschnitt durch eine elektrische Maschine.

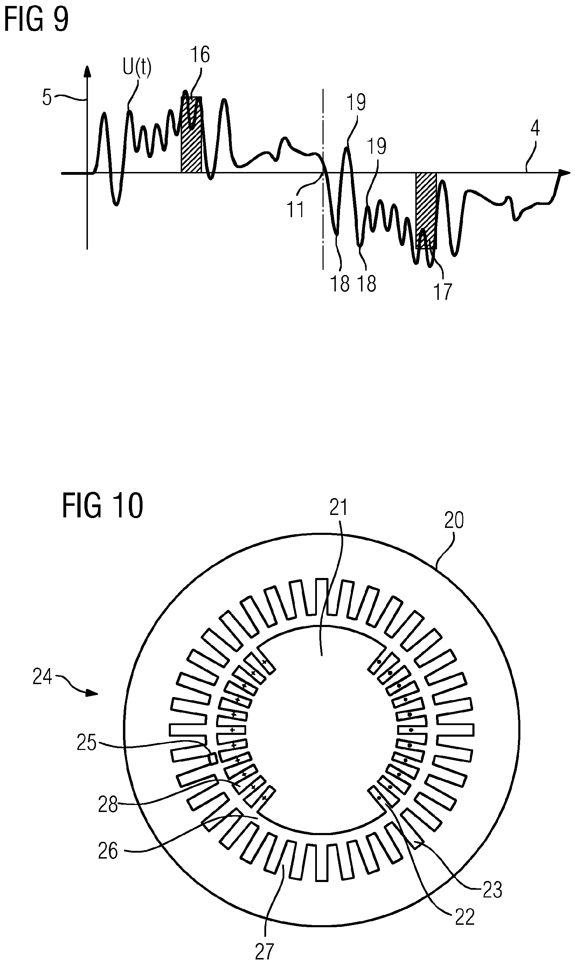

Figur 10 zeigt einen Schnitt durch eine elektrische Maschine 24. Die elektrische Maschine 24 weist radial außen liegend einen Stator 20 und radial innen liegend einen Läufer 21 auf. Der Stator 20 weist eine Mehrzahl an in Umfangsrichtung nebeneinander angeordneten Statornuten 23 auf, in die elektrische Leiter eingebracht sind. Jede der Statornuten 23 ist in Umfangsrichtung jeweils von zwei Statorzähnen 27 begrenzt. Der Läufer 21 weist eine Mehrzahl an in Umfangsrichtung nebeneinander angeordneten Läufernuten 22 auf, in die zum Erzeugen eines magnetischen Feldes elektrische Leiter eingebracht sind. In jeder Läufernut 22 ist eine Mehrzahl an elektrischen Teilleitern eingebracht, die jeweils von einer elektrischen Isolation umhüllt sind, um die Teilleiter gegeneinander elektrisch zu isolieren. Eine Beschädigung der Isolation kann zu einem Windungsschluss führen. Jede der Läufernuten 22 ist in Umfangsrichtung jeweils von zwei Läuferzähnen 28 begrenzt. Die Polpaarzahl der elektrischen Maschine 24 aus Figur 10 ist eins. Zwischen dem Stator 20 und dem Läufer 21 ist ein Luftspalt 26 angeordnet. In den Luftspalt 26 ist zum Messen einer Änderung des magnetischen Flusses eine Spule 25 eingebracht. Die Spule 25 in Figur 10 ist an der radial innen liegenden Fläche einer der Statorzähne 27 angebracht.

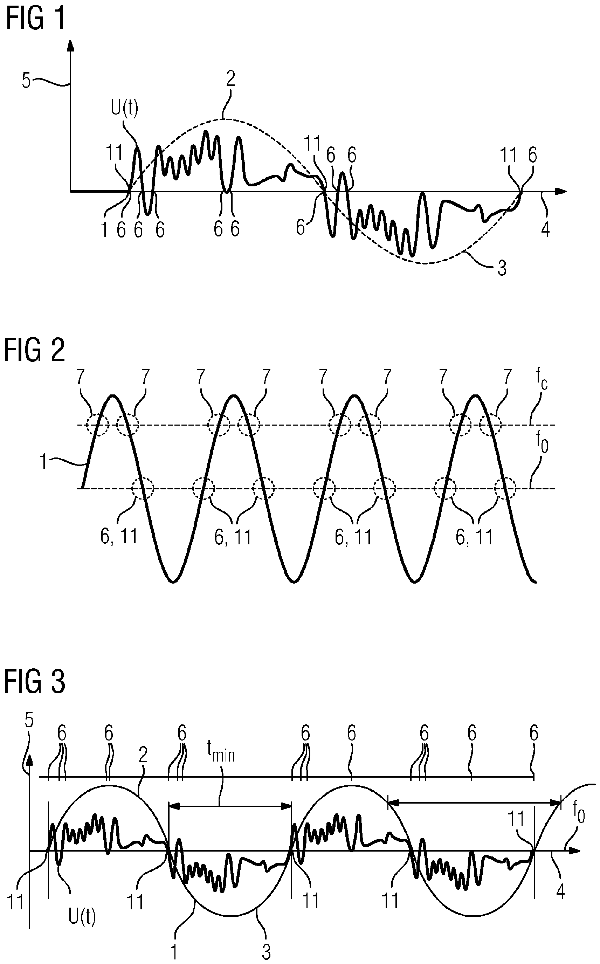

Figur 1 zeigt eine Auftragung eines mittels der Spule 25 aufgenommenen Signalverlaufs $U(t)$. Über der Abszisse 4 ist die Zeit und über die Ordinate 5 ist die elektrische Spannung oder die Stromstärke aufgetragen. Ebenfalls ist in der Auftragung eine Grundharmonische 1 der Form $U_G=\hat{U}*\sin(\omega t)$ eingezeichnet, wobei $\omega$ die Kreisfrequenz der Rotation des Läufers 21 und $\hat{U}$ die Amplitude ist. Weil die Polpaarzahl der elektrischen Maschine 24 eins ist, besteht jede Schwingungsperiode der Grundharmonischen 1 aus einer ersten Halbwelle 2, die sich durch ein positives Vorzeichen für $U_G(t)$ auszeichnet, und einer zweiten Halbwelle 3, die sich durch ein negatives Vorzeichen für $U_G(t)$ auszeichnet. Jede der beiden Halbwellen 2, 3 entspricht einer halben Umdrehung des Läufers 21. In dem erfindungsgemäßen Verfahren werden diejenigen Abschnitte des Signalverlaufs $U(t)$ identifiziert, die zu der ersten Teilwelle 2 beziehungsweise zu der zweiten Teilwelle 3 gehören. Anschließend wird ein Vergleich der beiden Abschnitte durchgeführt. Wie es aus Figur 1 ersichtlich ist, entsprechen nicht alle Nulldurchgänge 6 des Signalverlaufs $U(t)$ einem Nulldurchgang 11 der Grundharmonischen 1. Ein Nulldurchgang bezeichnet einen Punkt in dem Signalverlauf $U(t)$, bei dem $U(t)=0$ ist.

In Figur 2 ist die Grundharmonische 1 mit ihren Nulldurchgängen 11 dargestellt. Die Nulldurchgänge 11 sind in Figur 2 als Schnittpunkte der Grundharmonischen 1 mit der Funktion $f_0=0$ dargestellt. Wird der Signalverlauf $U_G(t)$ mit einem Offset c korrigiert, so dass der korrigierte Signalverlauf die Form $U_G(t)-c$ annimmt, ändert sich der Zeitabstand von zwei unmittelbar aufeinander folgenden Nulldurchgängen 7 im Vergleich mit den Nulldurchgängen 11 des Signalverlaufs $U_G(t)$. Die Nulldurchgänge 7 des korrigierten Signalverlaufs $U(t)-c$ sind in Figur 2 als Schnittpunkte mit der Funktion $f_c(t)=c$, wobei $c>0$ dargestellt. Dabei ist der Zeitabstand von zwei unmittelbar aufeinander folgenden Nulldurchgängen 7 abwechselnd kürzer und länger als der Zeitabstand von zwei unmittelbar aufeinander folgenden Nulldurchgängen 11 des Signalverlauf $U_G(t)$.

In Figuren 3 bis 6 ist dargestellt, wie diejenigen der Nullstellen 6 des Signalverlaufs $U(t)$ gefunden werden, die einer Nullstelle 11 der Grundharmonischen 1 entsprechen. Dazu werden, wie in Figur 3 dargestellt, alle Nullstellen 6 des Signalverlaufs $U(t)$ bestimmt. In Figur 3 ist ebenfalls die Grundharmonische 1 eingezeichnet und eine Mindestdauer $t_{min}$, die der Zeitabstand von zwei unmittelbar benachbarten Nulldurchgängen 11 der Grundharmonischen 1 ist. Die Mindestdauer $t_{min}$ wird durch die Gleichung Mindestdauer $t_{min}=1/(f*2*n)$ abgeschätzt, wobei f die Drehfrequenz des Läufers 21 und n die Polpaarzahl der elektrischen Maschine 24 ist.

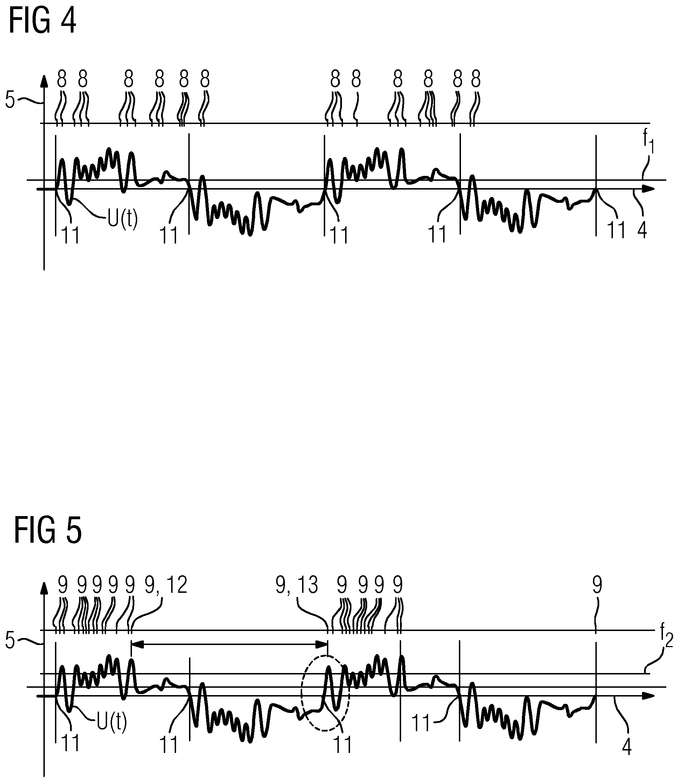

Wie es aus Figur 4 ersichtlich ist, werden nach dem Bestimmen der Nulldurchgänge 6 des Signalverlaufs $U(t)$ Nulldurchgänge 8 in einem mit einem Offset $c_1$ korrigierten Signalverlauf $U(t)-c_1$ bestimmt. Die Nulldurchgänge 8 in dem Signalverlauf $U(t)-c_1$ sind in Figur

4 als Schnittpunkte des Signalverlaufs U(t) mit der Funktion $f_1(t)=c_1$ dargestellt. Zur Bestimmung des Offsets $c_1$ wird zuerst das globale Maximum in dem Signalverlauf U(t) bestimmt und $c_1$ wird anschließend positiv und als ein Bruchteil des globalen Maximums gewählt, beispielsweise als ein Zehntel des globalen Maximums. Es werden nun diejenigen unmittelbar aufeinander folgenden Nulldurchgänge 8 in dem Signalverlauf $U(t)-c_1$ gesucht, deren Zeitabstand länger als die Mindestdauer $t_{min}$ ist. Wie es aus Figur 4 ersichtlich ist, kann mit dem Offset $c_1$ kein solches Paar an unmittelbar aufeinanderfolgenden Nulldurchgängen 8 in dem Signalverlauf $U(t)-c_1$ gefunden werden.

Aus diesem Grund werden anschließend Nulldurchgänge 9 in einer mit einem Offset $c_2$ korrigierten Signalverlauf $U(t)-c_2$ bestimmt. Die Nulldurchgänge 9 in dem Signalverlauf $U(t)-c_2$ sind in Figur 5 als Schnittpunkte des Signalverlaufs U(t) mit der Funktion $f_2(t)=c_2$ dargestellt. Dabei wird der Offset $c_2$ um den Bruchteil gegenüber $c_1$ erhöht. Es werden nun diejenigen unmittelbar aufeinander folgenden Nulldurchgänge 9 in dem Signalverlauf $U(t)-c_2$ gesucht, deren Zeitabstand länger als die Mindestdauer $t_{min}$ ist. Wie es aus Figur 5 ersichtlich ist können zwei solcher Paare an unmittelbar aufeinander folgender Nulldurchgänge 9 in dem Signalverlauf $U(t)-c_2$ gefunden werden. Jedes der beiden Paare weist einen ersten Nulldurchgang 12 und einen zweiten Nulldurchgang 13 auf, wobei der erste Nulldurchgang 12 zeitlich vor dem zweiten Nulldurchgang 13 liegt. Diejenigen der Nulldurchgänge 6 des Signalverlaufs U(t), die den Nulldurchgängen 11 der Grundharmonischen 1 entsprechen, werden als diejenigen Nulldurchgänge identifiziert, die zeitlich zwischen dem ersten Nulldurchgang 12 und zweiten dem Nulldurchgang 13 liegen und zeitlich am nahesten an dem ersten Nulldurchgang 12 und dem zweiten Nulldurchgang 13 liegen. Figur 5 zeigt ein Detail aus Figur 4, nämlich den zweiten Nulldurchgang 13 zusammen mit den Nulldurchgang 11 der Grundharmonischen 1.

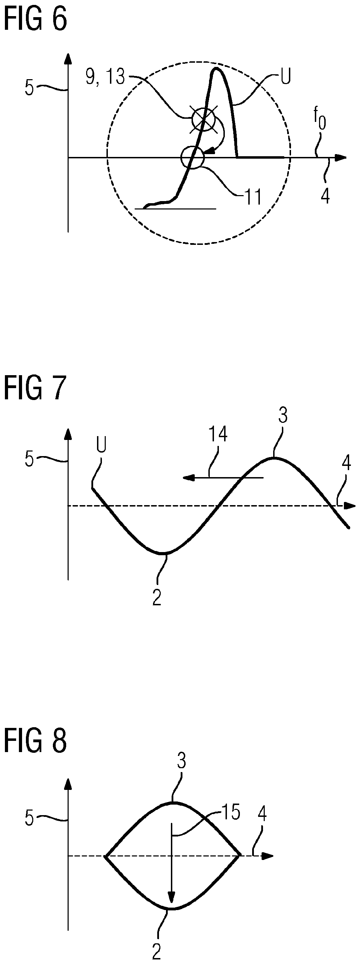

Figuren 7 und 8 zeigen schematisch, wie die erste Halbwelle 2 mit der zweiten Halbwelle 3 verglichen wird. Dazu werden aus dem Signalverlauf U(t) anhand der Nulldurchgänge 11 die jeweiligen Startpunkte und Endpunkte für die erste Halbwelle 2 und die zweite Halbwelle 3 extrahiert. Beispielsweise kann dies dadurch erfolgen, dass anhand eines gefundenen Paares an unmittelbar aufeinander folgenden Nulldurchgängen 11 der Grundharmonischen 1 zuerst eine der beiden Halbwellen 2, 3 als der Abschnitt des Signalverlaufs U(t) extrahiert wird, der von dem Paar begrenzt ist. Die zweite der beiden Halbwellen 2, 3 kann beispielsweise als der Abschnitt des Signalverlaufs U(t) extrahiert werden, der um eine Dauer, die dem Zeitabstand des Paares entspricht, vor dem ersten Nulldurchgang 12 des Paares oder nach dem zweiten Nulldurchgang 13 des Paares liegt. Es ist ebenso denkbar, dass weitere Nulldurchgänge 11 der Grundharmonischen 1 gefunden werden, in dem ein negativer Offset d in Richtung zu dem globalen Minimum des Signalverlaufs U(t) variiert wird. Durch Variieren des positiven Offsets c und des negativen Offsets d können insgesamt drei unmittelbar aufeinander folgende Nulldurchgänge 11 der Grundharmonischen 1 gefunden werden, wobei die zeitlich ersten beiden der drei Nulldurchgänge 11 die erste Halbwelle 2 und die zeitlich zweite und dritte der drei Nulldurchgänge die zweite Halbwelle 3 begrenzen.

Wie es aus Figuren 7 und 8 ersichtlich ist werden die beiden Halbwellen 2, 3 durch Verschieben einer der beiden Halbwellen 2, 3 in Richtung der Abszisse 4 zur Deckung gebracht, wie es durch den Pfeil 14 angedeutet ist. Die beiden Halbwellen 2, 3 werden miteinander addiert, wie es durch den Pfeil 15 in Figur 8 angedeutet ist. In einem fehlerfreien Fall ist der zeitliche Signalverlauf der miteinander addierten Halbwellen 2, 3 Null. Ist der Signalverlauf der miteinander addierten Halbwellen 2, 3 ungleich Null, so muss dieser Signalverlauf analysiert werden, ob tatsächlich ein Windungsschluss vorliegt oder ob externe Einflüsse eine Verfälschung in dem Signalverlauf U(t) hervorgerufen haben.

Ein typischer Fehlerfall ist in Figur 9 dargestellt. Es liegt ein erstes Fehlersignal 16 in der ersten Halbwelle 2 und ein zweites Fehlersignal 17 in der zweiten Halbwelle 3 vor. Der Zeitabstand der Fehlersignale 16, 17 zu dem Nullpunkt 11, der die beiden Halbwellen 2, 3 voneinander trennt, ist identisch. Die Fehlersignale 16, 17 können einer der Läufernuten 23 zugeordnet werden, weil ein lokales Minimum 18 in dem Signalverlauf U(t) einem Läuferzahn 28 und ein lokales Maximum 19 in dem Signalverlauf U(t) einer Läufernut 23 entspricht.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zum Detektieren von Windungsschlüssen in einer elektrischen Maschine (24), mit den Schritten:

   a) Anordnen einer Spule (25) in einen zwischen dem Läufer (21) und dem Stator (20) der elektrischen Maschine (24) angeordneten Luftspalt (26);
   b) Berechnen einer Mindestdauer ($t_{min}$) von zwei zeitlich unmittelbar aufeinanderfolgen Nulldurchgängen (11) eines mittels der Spule (25) erzeugten Signalverlaufs U(t) unter Heranziehen der Drehfrequenz und der Polpaarzahl der elektrischen Maschine (24);
   c) Aufnehmen im Betrieb der elektrischen Maschine (24) des mittels der Spule (25) erzeugten Signalverlaufs U(t), der mindestens die Dauer einer Läuferumdrehung aufweist; **gekennzeichnet durch** die weiteren Schritte

d) Bestimmen der Nulldurchgänge (6) des Signalverlaufs U(t) und Speichern der Zeitpunkte dieser Nulldurchgänge (6);

e) Bestimmen der Nulldurchgänge (7, 8) des mit einem Offset c korrigierten Signalverlaufs U(t)-c und Identifizieren mindestens eines Paares (12, 13) an unmittelbar aufeinander folgenden Nulldurchgängen (7, 8), dessen Zeitabstand länger als die Mindestdauer ($t_{min}$) ist, wobei c ungleich Null ist;

f) in dem Fall, dass in Schritt e) kein Paar (12, 13) identifiziert wurde, Wiederholen von Schritt e) bis ein Paar (12, 13) identifiziert wird, wobei der Offset c in Richtung von dem Nullpunkt zu einem globalen Extremwert des Signalverlaufs U(t) variiert wird;

g) Identifizieren mindestens eins der beiden der gespeicherten Zeitpunkte, die zeitlich zwischen und zeitlich am nahesten an dem Paar (12, 13) liegen;

h) Extrahieren aus dem Signalverlauf U(t) von zwei Halbwellen (2, 3) unter Heranziehen der in Schritt g) identifizierten Zeitpunkte, wobei jede Halbwelle (2, 3) einer halben Umdrehung des Läufers (21) entspricht;

i) Vergleichen der beiden Halbwellen (2, 3).

2. Verfahren gemäß Anspruch 1, mit den Schritten:

e1) Bestimmen der Nulldurchgänge (7, 8) des mit einem Offset d korrigierten Signalverlaufs U(t)-d und Identifizieren mindestens eines Paares (12, 13) an unmittelbar aufeinander folgenden Nulldurchgängen (7, 8), dessen Zeitabstand länger als die Mindestdauer ($t_{min}$) ist, wobei d ungleich Null ist und das entgegengesetzte Vorzeichen zu c hat;

f1) in dem Fall, dass in Schritt e1) kein Paar (12, 13) identifiziert wurde, Wiederholen von Schritt e1) bis ein Paar (12, 13) identifiziert wird, wobei der Offset d in Richtung von dem Nullpunkt zu dem anderen globalen Extremwert des Signalverlaufs U(t) variiert wird; und wobei in Schritt h eine der beiden Halbwellen (2, 3) unter Heranziehen der in Schritt e1) identifizierten Zeitpunkte extrahiert wird.

3. Verfahren gemäß Anspruch 1 oder 2, wobei die Polpaarzahl der elektrischen Maschine (24) eins ist und jede der beiden Halbwellen (2, 3) von jeweils zwei der in Schritt g) und/oder g1) identifizierten Zeitpunkten begrenzt ist, die unmittelbar aufeinander folgen.

4. Verfahren gemäß Anspruch 1 oder 2, wobei die Polpaarzahl der elektrische Maschine (24) größer als eins ist, und jede der Halbwellen (2, 3) von einer der Polpaarzahl entsprechenden Anzahl an Teilwellen gebildet ist, wobei jede Teilwelle von jeweils zwei der in Schritt g) und/oder g1) identifizierten und unmittelbar aufeinander folgenden Zeitpunkten begrenzt ist.

5. Verfahren gemäß einem der Ansprüche 1 bis 4, wobei in Schritten d), e) und/oder e1) die Nulldurchgänge (6 bis 9) mittels Bilden von $y_0 = U_{t=\alpha} * U_{t=\alpha+1}$ für alle Punkte des Signalverlaufs U(t) und des korrigierten Signalverlaufs U(t)-c bestimmt werden, wobei $U_{t=\alpha}$ ein Signalwert in U(t) oder U(t)-c ist und $U_{t=\alpha+1}$ der unmittelbar darauf folgende Signalwert ist.

6. Verfahren gemäß Anspruch 5, wobei in dem Fall, dass $y_0$ negativ ist, zum Bestimmen des Nulldurchgangs (6 bis 9) die beiden zu $U_{t=\alpha}$ und $U_{t=\alpha+1}$ gehörigen Punkte linear interpoliert werden.

7. Verfahren gemäß einem der Ansprüche 1 bis 6, wobei der Signalverlauf U(t) die in der Spule (25) erzeugte elektrische Spannung oder die in der Spule (25) erzeugte Strömstärke aufweist.

8. Verfahren gemäß einem der Ansprüche 1 bis 7, wobei der in Schritt c) aufgenommene Signalverlauf U(t) mittels eines Filters, insbesondere ein Beziér-Filter, ein Median-Filter und/oder ein Gradienten-Filter, geglättet wurde.

9. Verfahren gemäß einem der Ansprüche 1 bis 8, wobei die elektrische Maschine (24) ein Generator, insbesondere eine Synchronmaschine, und/oder ein Elektromotor ist.

**Claims**

1. Method for detecting winding short-circuits in an electric machine (24), with the steps of:

a) arranging a coil (25) in an air gap (26) arranged between the rotor (21) and the stator (20) of the electric machine (24);

b) calculating a minimum duration ($t_{min}$) of two immediately sequential zero crossings (11) of a signal curve U(t) generated by means of the coil (25), taking the rotational frequency and the number of pole pairs of the electric machine (24) into account;

c) recording the signal curve U(t) generated by means of the coil (25) during operation of the electric machine (24), having at least the duration of one revolution of the rotor; **characterized by** the further steps of

d) determining the zero crossings (6) of the signal curve U(t) and storing the times of said zero crossings (6);

e) determining the zero crossings (7, 8) of the signal curve U(t)-c corrected by an offset c, and identifying at least one pair (12, 13) of immediately sequential zero crossings (7, 8), the time interval of which is longer than the minimum duration (tmin), where c is not equal to zero;

f) in the event that a pair (12, 13) is not identified in step e), repeating step e) until a pair (12, 13) is identified, wherein the offset c is varied in the direction from the zero point to a global extreme value of the signal curve U(t);

g) identifying at least one of the two stored times which lie between and closest in time to the pair (12, 13), and;

h) extracting two half-waves (2, 3) from the signal curve U(t) using the times identified in step g), wherein each half-wave (2, 3) corresponds to half a revolution of the rotor (21);

i) comparing the two half-waves (2, 3).

2. Method according to Claim 1, with the steps of:

e1) determining the zero crossings (7, 8) of the signal curve U(t)-d corrected with an offset d, and identifying at least one pair (12, 13) of immediately sequential zero crossings (7, 8), whose time interval is longer than the minimum duration (tmin), where d is not equal to 0 and has the opposite arithmetic sign to c;

f1) in the event that a pair (12, 13) is not identified in step e1), repeating step e1) until a pair (12, 13) is identified, wherein the offset d is varied in the direction from the zero point to the other global extreme value of the signal curve U(t); and wherein in step h one of the two half-waves (2, 3) is extracted making use of the time points identified in step e1).

3. Method according to Claim 1 or 2, wherein the number of pole pairs of the electric machine (24) is one, and each of the two half-waves (2, 3) is delimited respectively by two of the time points identified in step g) and/or g1) that are immediately sequential.

4. Method according to Claim 1 or 2, wherein the number of pole pairs of the electric machine (24) is larger than one, and each of the half-waves (2, 3) is formed of a number of partial waves corresponding to the number of pole pairs, wherein each partial wave is delimited in each case by two of the immediately sequential times identified in step g) and/or g1).

5. Method according to one of Claims 1 to 4,

wherein in steps d), e) and/or e1), the zero crossings (6 to 9) are determined by formation of $y_0 = U_{t=\alpha} * U_{t=\alpha+1}$ for all the points of the signal curve U(t) and of the corrected signal curve U(t)-c, where $U_{t=\alpha}$ is a signal value in U(t) or U(t)-c, and $U_{t=\alpha+1}$ is the immediately sequential signal value.

6. Method according to Claim 5, wherein, in the case where $y_0$ is negative, the two points associated with $U_{t=\alpha}$ and $U_{t=\alpha+1}$ are linearly interpolated for determination of the zero crossing (6 to 9).

7. Method according to one of Claims 1 to 6, wherein the signal curve U(t) exhibits the electrical voltage generated in the coil (25) or the current magnitude generated in the coil (25).

8. Method according to one of Claims 1 to 7, wherein the signal curve U(t) recorded in step c) is smoothed by means of a filter, in particular a Bezier filter, a median filter and/or a gradient filter.

9. Method according to one of Claims 1 to 8, wherein the electric machine (24) is a generator, in particular a synchronous machine, and/or an electric motor.

**Revendications**

1. Procédé de détection de courts-circuits entre spires dans une machine électrique (24), comprenant les étapes consistant à :

a) disposer une bobine (25) dans un entrefer (26) ménagé entre le rotor (21) et le stator (20) de la machine électrique (24) ;

b) calculer une durée minimale ($t_{min}$) de deux passages par zéro (11) immédiatement consécutifs d'une courbe U(t) d'un signal généré par la bobine (25), en se référant à la fréquence de rotation et au nombre de paires de pôles de la machine électrique (24) ;

c) enregistrer, pendant le fonctionnement de la machine électrique (24), la courbe U(t) du signal généré par la bobine (25), qui a au moins la durée d'une révolution du rotor ;

**caractérisé par** les étapes suivantes :

d) détermination des passages par zéro (6) de la courbe U(t) du signal et mémorisation des instants de ces passages par zéro (6) ;

e) détermination des passages zéro (7, 8) de la courbe U(t)-c du signal corrigé d'un décalage c et identification d'au moins une paire (12, 13) de passages par zéro (7, 8) immédiatement consécutifs dont l'espacement dans le temps est supérieur à la durée minimale ($t_{min}$), c étant dif-

férent de zéro ;

f) dans le cas où aucune paire (12, 13) n'a été identifiée à l'étape e), répétition de l'étape e) jusqu'à ce qu'une paire (12, 13) soit identifiée, le décalage c variant dans le sens allant du point zéro vers un extremum global de la courbe U(t) du signal ;

g) identification d'au moins un des deux instants mémorisés qui se situent temporellement entre la paire (12, 13) et temporellement le plus près de ladite paire ;

h) extraction, à partir de la courbe U(t) du signal, de deux demi-ondes (2, 3) en se référant aux instants identifiés à l'étape g), chaque demi-onde (2, 3) correspondant à une demi-révolution du rotor (21) ;

i) comparaison des deux demi-ondes (2, 3).

2. Procédé selon la revendication 1, comprenant les étapes consistant à :

e1) déterminer les passages par zéro (7, 8) de la courbe U(t)-d du signal corrigé d'un décalage d et identifier au moins une paire (12, 13) de passages par zéro (7, 8) immédiatement consécutifs dont l'espacement dans le temps est supérieur à la durée minimale ($t_{min}$), d n'étant pas nul et étant de signe opposé à c ;

f1) dans le cas où aucune paire (12, 13) n'a été identifiée à l'étape e1), répéter l'étape e1) jusqu'à ce qu'une paire (12, 13) ait été identifié, le décalage d variant dans le sens allant du point zéro vers l'autre extremum global de la courbe U(t) du signal ; et une des deux demi-ondes (2, 3) étant extraite, à l'étape h, en se référant aux instants identifiés à l'étape e1).

3. Procédé selon la revendication 1 ou 2, dans lequel le nombre de paires polaires de la machine électrique (24) est un et chacune des deux demi-ondes (2, 3) est limitée respectivement par deux des instants identifiés à l'étape g) et/ou g1) qui sont immédiatement consécutifs.

4. Procédé selon la revendication 1 ou 2, dans lequel le nombre de paires polaires de la machine électrique (24) est supérieur à un et chacune des demi-ondes (2, 3) est formée par un nombre d'ondes partielles correspondant au nombre de paires polaires, dans lequel chaque onde partielle est limitée respectivement par deux des instants identifiés à l'étape g) et/ou g1) et immédiatement consécutifs.

5. Procédé selon l'une des revendications 1 à 4, dans lequel, aux étapes d), e) et/ou e1), les passages par zéro (6 à 9) sont déterminés en formant $y_0 = U_{t=\alpha}$ * $U_{t=\alpha+1}$ pour tous les points de la courbe U(t) du signal et de la courbe U(t)-c du signal corrigé, dans lequel $U_{t=\alpha}$ est une valeur du signal dans U(t) ou U(t)-c et $U_{t=\alpha+1}$ est la valeur du signal immédiatement consécutive.

6. Procédé selon la revendication 5, dans lequel, dans le cas où $y_0$ est négatif, le passage par zéro (6 à 9) est déterminé par interpolation linéaire des deux points correspondant à $U_{t=\alpha}$ et $U_{t=\alpha+1}$.

7. Procédé selon l'une des revendications 1 à 6, dans lequel la courbe U(t) du signal présente la tension électrique générée dans la bobine (25) ou le courant généré dans la bobine (25).

8. Procédé selon l'une des revendications 1 à 7, dans lequel la courbe U(t) du signal enregistrée à l'étape c) a été lissée au moyen d'un filtre, notamment d'un filtre Bézier, un filtre médian et/ou un filtre de gradient.

9. Procédé selon l'une des revendications 1 à 8, dans lequel la machine électrique (24) est un générateur, notamment une machine synchrone et/ou un moteur électrique.

FIG 1

FIG 2

FIG 3

## FIG 4

## FIG 5

## FIG 6

## FIG 7

## FIG 8

FIG 9

FIG 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2457590 A